# EUROPEAN PATENT APPLICATION

(11) **EP 4 585 973 A1**
(43) Date of publication of application: **16.07.2025**
(21) Application number: 23863490.1
(22) Date of filing: 06.09.2023
(51) Int. Cl.: G01T 1/24, H01L 31/08, H01L 31/0203, H01L 31/0224, H01L 31/0264

(54) **X-RAY DETECTOR**

(30) Priority: 06.09.2022 KR 20220112736
(71) Applicant: Rayence Co., Ltd., Hwaseong-si, Gyeonggi-do 18449 (KR); Vatech Ewoo Holdings Co., Ltd., Hwaseong-si, Gyeonggi-do 18449 (KR)
(72) Inventor: KIM, Jung Do, Hwaseong-si Gyeonggi-do 18449 (KR); LEE, Gun Ha, Hwaseong-si Gyeonggi-do 18449 (KR)
(74) Representative: Lorenz & Kollegen
(86) International application number: PCT/KR2023/013309
(87) International publication number: WO 2024/054024

(57) **Abstract**

The present invention provides an X-ray detector comprising: a sensor panel which includes a photoelectric conversion device disposed on a substrate; a printed circuit board which is disposed at the rear surface of the sensor panel and includes a bias pad; and a conductive sheet which surrounds the sensor panel and the printed circuit board so as to be connected to the photoelectric conversion device and the bias pad.

## Description

### Technical Field

The present disclosure relates to an X-ray detector.

### Background Art

In recent years, digital detectors have become widely used for X-ray imaging. Digital X-ray detectors are divided into indirect-conversion and direct-conversion types.

Indirect-conversion X-ray detectors have a scintillator that first converts X-rays into visible light, and then the visible light is converted to electrical signals. In contrast, direct conversion X-ray detectors use a photoconductor to convert X-rays directly into electrical signals without the need to convert the X-rays into visible light.

In a direct conversion X-ray detector, a photoelectric conversion element is placed on the front of a sensor panel. The photoelectric conversion element includes a first electrode that is a pixel electrode or a lower electrode, a photoconductor, and a second electrode that is a common electrode or an upper electrode, and a bias voltage is applied to the upper electrode.

To this end, a transmission wire is used to connect the upper electrode to a bias pad of a printed circuit board placed on the back of the sensor panel, and the transmission wire is arranged to run over the side of the sensor panel.

In the case of such a bias voltage application structure, it is very difficult to coat a necessary encapsulation film to protect the transmission wire or prevent moisture from penetrating into the sensor panel.

### Disclosure

### Technical Problem

An objective of the present disclosure is to provide a method for stably sealing a sensor panel, etc. by improving the bias voltage application structure of a direct conversion X-ray detector.

### Technical Solution

In order to achieve the above mentioned objective, there is provided an X-ray detector including: a sensor panel configured to include a photoelectric conversion element disposed on a substrate; a printed circuit board disposed on the rear surface of the sensor panel and configured to include a bias pad; and a conductive sheet configured to cover the sensor panel and the printed circuit board and connect to the photoelectric conversion element and the bias pad.

The X-ray detector may further include an encapsulation film configured to surround at least a portion of a sensor assembly including the sensor panel, the printed circuit board, and the conductive sheet.

The encapsulation film may contain parylene.

The printed circuit board may include a connector disposed on a rear surface thereof, and the encapsulation film may cover the conductive sheet and may cover a rear surface of the printed circuit board excluding the connector.

The photoelectric conversion element may include a first electrode on the substrate, a photoconductive layer on the first electrode, and a second electrode located on the photoconductive layer and connected to the conductive sheet.

The photoconductive layer may include at least one of PV (perovskite), CdTe, CdZnTe, PbO, PbI₂, HgI₂, GaAs, Se, TlBr, and BiI₃.

The bias pad may be disposed on at least one of a plurality of edge-side areas constituting an edge of the printed circuit board.

The conductive sheet may contain a metal foil or grid made of gold (Au), platinum (Pt), or an alloy thereof.

### Advantageous Effects

According to the present disclosure, a bias voltage can be applied from a bias pad to a second electrode using a conductive sheet that comes into close contact with a sensor panel, a photoelectric conversion element, and a printed circuit board.

Accordingly, the uniformity of the bias voltage of the second electrode can be maximized and the inflow of external noise can be effectively blocked.

In addition, the conductive sheet can prevent the infiltration of moisture or foreign substances into the sensor panel and protect the sensor panel, and can more firmly combine the sensor panel and the printed circuit board.

Furthermore, since the conductive sheet does not substantially change the appearance of the X-ray detector, the difficulty of performing encapsulating film coating when using a transmission wire can be effectively eliminated.

### Description of Drawings

FIG. 1 is a perspective view schematically showing a direct X-ray detector according to an embodiment of the present disclosure.
FIG. 2 is a cross-sectional view schematically showing an X-ray detector according to an embodiment of the present disclosure.
FIG. 3 is a perspective view schematically showing a sensor assembly according to an embodiment of the present disclosure.
FIG. 4 is an exploded perspective view schematically showing a sensor assembly according to an embodiment of the present disclosure.
FIG. 5 is a cross-sectional view schematically showing a part of a sensor panel according to an embodiment of the present disclosure.
FIG. 6 is a plan view schematically showing a printed circuit board according to an embodiment of the present disclosure.

### Best Mode

Hereinafter, embodiments of the present disclosure will be described in detail with reference to the drawings.

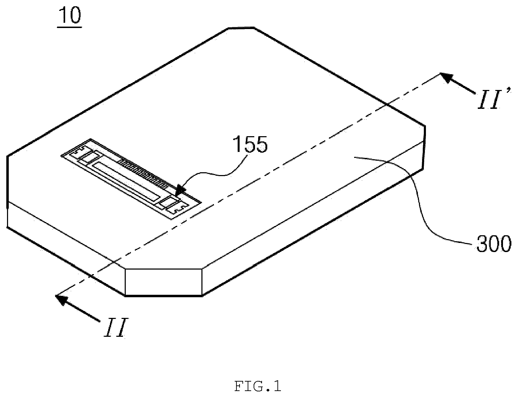

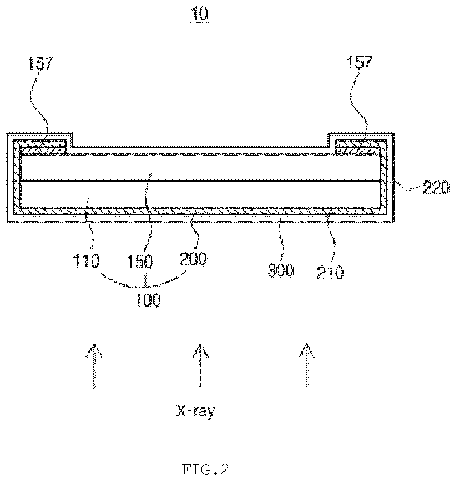

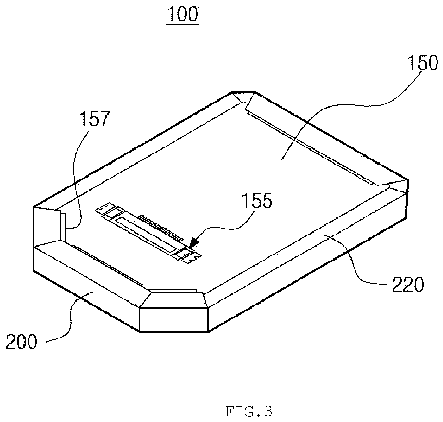

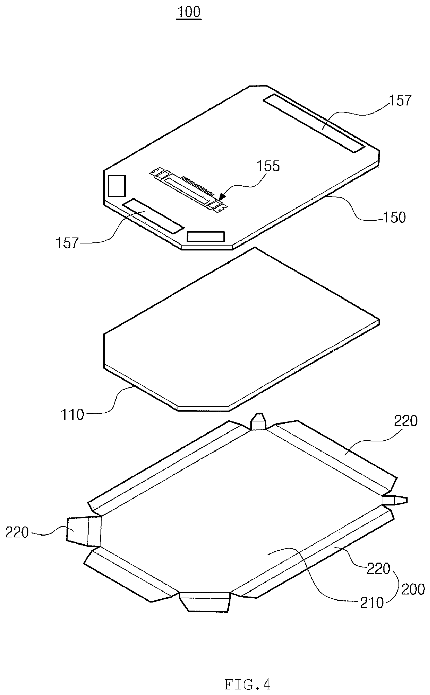

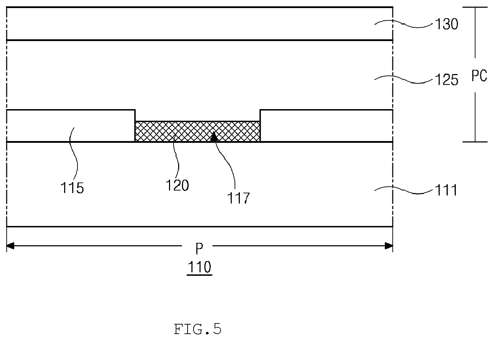

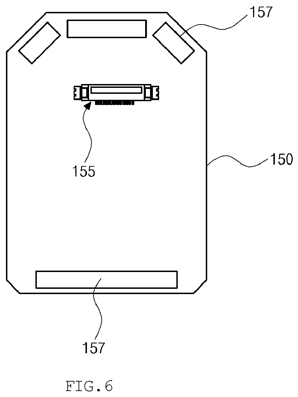

FIG. 1 is a perspective view schematically showing a direct X-ray detector according to an embodiment of the present disclosure. FIG. 2 is a cross-sectional view schematically showing an X-ray detector according to an embodiment of the present disclosure, taken along the cutting line II-II' in FIG. 1. FIG. 3 is a perspective view schematically showing a sensor assembly according to an embodiment of the present disclosure. FIG. 4 is an exploded perspective view schematically showing a sensor assembly according to an embodiment of the present disclosure. FIG. 5 is a cross-sectional view schematically showing a part of a sensor panel according to an embodiment of the present disclosure. FIG. 6 is a plan view schematically showing a printed circuit board according to an embodiment of the present disclosure.

Referring to FIGS. 1 to 6, a direct X-ray detector 10 according to an embodiment of the present disclosure may directly detect X-rays and generate an electrical signal. The X-ray detector 10 may be an intra oral sensor, a panoramic sensor, or a CT sensor.

The X-ray detector 10 may include a sensor assembly 100, and an encapsulation film (or protective film) 300 that directly surrounds the outside of the sensor assembly 100.

The sensor assembly 100 may include a sensor panel 110, a conductive sheet 200 disposed in front of the sensor panel 110, and a printed circuit board 150 disposed behind the sensor panel 110.

The sensor panel 110 corresponds to a direct conversion-type sensor panel that directly converts X-rays incident through the front surface (or incident surface) thereof into electrical signals.

In the sensor panel 110, pixels P, which are basic units that perform a photoelectric conversion function, may be arranged in a matrix form along a plurality of row lines and a plurality of column lines in an effective area (i.e., active area) for acquiring an image.

In addition, although not specifically shown, in the sensor panel 110, a plurality of scan wires may extend along one direction (e.g., row direction) and a plurality of readout wires may extend along a direction intersecting the scan wires (e.g., column direction), and each pixel P may be connected to the corresponding scan wire and readout wire.

An example of the structure of the pixel P of the sensor panel 110 will be described with reference to FIG. 5. In each pixel P, a photoelectric conversion element PC that converts X-rays into an electrical signal may be provided on a substrate 111.

In this case, as the substrate 111 used in the sensor panel 100, for example, a CCD substrate, a CMOS substrate, a TFT substrate, etc. may be used, but is not limited thereto. In an embodiment of the present disclosure, for convenience of explanation, the case of using a CMOS substrate is taken as an example.

A protective film 115 may be provided on the surface of the substrate 111. Additionally, a pad hole 117 may be formed in the protective film 115 for each pixel P. A lower electrode 120 of each pixel P may be configured in the pad hole 117. The lower electrode 120 is an electrode constituting the photoelectric conversion element PC and corresponds to a first electrode (or pixel electrode) 120. A driving voltage may be applied to the first electrode 120.

A photoconductive layer 125 may be formed on the substrate 111 on which the first electrode 120 is configured. The photoconductive layer 125 generates electron-hole pairs when X-rays are incident.

As the photoconductive layer 125, a material that has excellent charge transfer characteristics, high absorption coefficient, low dark current, and low electron-hole pair generation energy may be used. For example, at least one of photoconductive material groups such as PV (perovskite), CdTe, CdZnTe, PbO, PbI₂, HgI₂, GaAs, Se, TlBr, and BiI₃ may be used.

An upper electrode 130 may be provided on the substrate 111 on which the photoconductive layer 125 is formed. The upper electrode 130 is another electrode constituting the photoelectric conversion element PC and corresponds to a second electrode (or common electrode) 130. The second electrode 130 may be commonly formed throughout the entire active area where the pixels P of the sensor panel 110 are formed.

A bias voltage may be applied to the second electrode 130, and the bias voltage may have a lower potential than the driving voltage of the first electrode 120.

The printed circuit board 150 may be placed on the rear surface of the sensor panel 110 configured as above. For example, the printed circuit board 150 may be attached to the rear surface of the sensor panel 110 using an adhesive.

The printed circuit board 150 may be provided with a connector 155 and a bias pad 157.

The connector 155 is connected to an external system through a cable, and various signals may be transmitted and received through the connector 155 and driving power may be received from the outside. The connector 155 may be placed on the rear surface of the printed circuit board 150.

The bias pad 157 corresponds to a terminal that outputs the bias voltage applied to the sensor panel 110.

The bias pad 157 may be disposed on the rear surface of the printed circuit board 150. Furthermore, the bias pad 157 may be disposed at the edge of the rear surface of the printed circuit board 150.

At this time, the bias pad 157 may be provided in at least one corner area among a plurality of corner areas constituting the edge of the printed circuit board 150. In this embodiment, an example is taken where the bias pads 157 are respectively formed in two corner areas facing each other.

The conductive sheet 200 is made of a thin metal foil or film and may be configured to surround the sensor panel 110 and the printed circuit board 150.

In this regard, the conductive sheet 200 may include: a cover portion 210 that covers the entire front surface of the sensor panel 110 and is connected to the second electrode 130; and a connection portion (or outer edge portion) 220 that extends outward from the cover portion 210 and is connected to the bias pad 157 of the printed circuit board 150.

Due to the conductive sheet 200 composed of the connection portion 220 and the cover portion 210 as described above, the bias voltage may be transmitted from the bias pad 157 to the second electrode 130 of the sensor panel 110.

The conductive sheet 200 is a metal having excellent conductivity and ductility, and may be made of, for example, gold (Au), platinum (Pt), or an alloy thereof, but is not limited thereto.

The cover portion 210 may have substantially the same shape as the sensor panel 110 in plan view. The cover portion 210 is attached to the front surface of the sensor panel 110 and may be electrically connected to the second electrode 130 of the sensor panel 110.

In this regard, for example, a conductive adhesive (for example, an anisotropic conductive film) is provided on the inner surface of the cover portion 210, and the cover portion 210 may be attached to the sensor panel 110 by means of the conductive adhesive.

Accordingly, the cover portion 210 and the second electrode 130 may be electrically connected.

The connection portion 220 may be attached to the side of the sensor panel 110 and the side of the printed circuit board 150, and may also be attached to the rear edge of the printed circuit board 150.

In this way, since the connection portion 220 is attached to the rear edge of the printed circuit board 150, the connection portion 220 may be electrically connected to the bias pad 157 located at the edge of the printed circuit board 150.

At this time, a conductive adhesive is provided on the inner surface of the connection portion 220 as in the case of the cover portion 210, and the connection portion 220 may be attached to the sensor panel 110 and the printed circuit board 150 by means of the conductive adhesive.

Meanwhile, the connection portion 220 may have a cut shape corresponding to the corners of the sensor panel 110. That is, the connection portion 220 may have a shape with a portion removed to correspond to the corners of the sensor panel 110. Accordingly, the connection portion 220 may be composed of divided parts corresponding to each of the sides (or corners) of the sensor panel 110 and the printed circuit board 150.

As above, as the connection portion 220 is connected to the bias pad 157 and the cover portion 210 is connected to the second electrode 130, the bias voltage output from the bias pad 157 may be provided to the second electrode 130 through the conductive sheet 200.

As such, in the bias voltage application structure of this embodiment, the uniformity of the bias voltage in the second electrode 130 may be maximized by using the conductive sheet 200, which is a conductor in the form of a surface (plane) that overlaps the entire surface of the second electrode 130.

Furthermore, by using the conductive sheet 200, which is a planar conductor, the inflow of external noise can be effectively blocked.

In addition, since the conductive sheet 200 is configured to substantially surround the sensor panel 110 and may function as an encapsulation film, the conductive sheet 200 may prevent and protect the sensor panel 110 from infiltration of moisture or foreign substances.

In addition, since the conductive sheet 200 is attached to both the sensor panel 110 and the printed circuit board 150, the conductive sheet 200 may serve to more firmly combine the sensor panel 110 and the printed circuit board 150 with each other.

As described above, the sensor assembly 100 in which the conductive sheet 200, the sensor panel 110, and the printed circuit board 150 are combined may be coated with an encapsulation material to form the encapsulation film 300, and the X-ray detector 10 may be manufactured accordingly.

At this time, as the encapsulation material, a polymer material such as parylene may be used, but is not limited thereto.

Meanwhile, in this embodiment, the sensor assembly 100 may be constructed by attaching the planar conductive sheet 200 to the sensor panel 110 and the circuit board 150. Accordingly, since the conductive sheet 200 does not substantially change the appearance of the X-ray detector 10, the difficulty of performing encapsulating film coating when using a transmission wire may be effectively eliminated. At this time, if necessary, the conductive sheet 200 may have a grid shape in addition to a planar shape.

As described above, by coating the encapsulation material directly on the sensor assembly 100, the encapsulation film 300 may be provided in a form that directly contacts the outer surface of the sensor assembly 100.

At this time, since the connector 155 of the printed circuit board 150 is coupled to the cable, the encapsulation film 300 may be formed to surround the sensor assembly 100 except for the connector portion, that is, to expose the connector 155.

In other words, the encapsulation film 300 may be formed to cover substantially the entire conductive sheet 200 and the rear surface of the printed circuit board 150 excluding the connector 155.

In this way, the encapsulation film 300 may be formed to surround the sensor assembly 100 excluding the connector 155. Accordingly, it is possible to prevent moisture or foreign substances from penetrating into the sensor panel 110.

In addition, the encapsulation film 300 may function as an outermost cover that surrounds all of the sensor panel 110, the printed circuit board 150, and the conductive sheet 200, thereby protecting and firmly combining the sensor panel 110, the printed circuit board 150, and the conductive sheet 200.

As described above, according to the embodiment of the present disclosure, the bias voltage may be applied from the bias pad to the second electrode using the conductive sheet that comes into close contact with the sensor panel and the printed circuit board.

Accordingly, the uniformity of the bias voltage of the second electrode may be maximized and the inflow of external noise may be effectively blocked.

In addition, the conductive sheet may prevent the infiltration of moisture or foreign substances into the sensor panel and protect the sensor panel, and may more firmly combine the sensor panel and the printed circuit board.

Furthermore, since the conductive sheet does not substantially change the appearance of the X-ray detector, the difficulty of performing encapsulating film coating when using a transmission wire may be effectively eliminated.

## Claims

1. An X-ray detector, comprising:
a sensor panel configured to include a photoelectric conversion element disposed on a substrate;
a printed circuit board disposed on a rear surface of the sensor panel and configured to include a bias pad; and
a conductive sheet configured to cover the sensor panel and the printed circuit board and connect to the photoelectric conversion element and the bias pad.

2. The X-ray detector of claim 1, further comprising:
an encapsulation film configured to surround at least a portion of a sensor assembly including the sensor panel, the printed circuit board, and the conductive sheet.

3. The X-ray detector of claim 2, wherein the encapsulation film contains parylene.

4. The X-ray detector of claim 2, wherein the printed circuit board includes a connector disposed on a rear surface thereof, and
the encapsulation film covers the conductive sheet and covers a rear surface of the printed circuit board excluding the connector.

5. The X-ray detector of claim 1, wherein the photoelectric conversion element includes a first electrode on the substrate, a photoconductive layer on the first electrode, and a second electrode located on the photoconductive layer and connected to the conductive sheet.

6. The X-ray detector of claim 5, wherein the photoconductive layer includes at least one of PV (perovskite), CdTe, CdZnTe, PbO, PbI₂, HgI₂, GaAs, Se, TlBr, and BiI₃.

7. The X-ray detector of claim 1, wherein the bias pad is disposed on at least one of a plurality of edge-side areas constituting an edge of the printed circuit board.

8. The X-ray detector of claim 1, wherein the conductive sheet contains a metal foil or grid made of gold (Au), platinum (Pt), or an alloy thereof.
